# EUROPÄISCHE PATENTSCHRIFT

(11) **EP 0 978 132 B1**
(45) Veröffentlichungstag und Bekanntmachung des Hinweises auf die Patenterteilung: **06.02.2002**
(21) Anmeldenummer: 97911119.2
(22) Anmeldetag: 27.09.1997
(51) Int. Cl.: H01H 5/02, H01H 25/06

(54) **DREHSCHALTER MIT TASTFUNKTION**
ROTARY SWITCH WITH KEYING FUNCTION
COMMUTATEUR TOURNANT A FONCTION DE TOUCHE

(30) Priorität: 23.04.1997 DE 29707302 U
(43) Veröffentlichungstag der Anmeldung: 09.02.2000
(73) Patentinhaber: ELMA Electronic AG, 8620 Wetzikon (CH)
(72) Erfinder: GESSNER, Heinz, CH-8335 Hittnau (CH)
(74) Vertreter: Heinen, Detlef
(86) Internationale Anmeldenummer: DE9702225
(87) Internationale Veröffentlichungsnummer: WO9848435

(56) Entgegenhaltungen:
- DE-A- 2 313 750
- DE-A- 3 119 227
- DE-U- 8 910 606
- DE-U- 29 707 302

## Beschreibung

### Technisches Gebiet

Die Erfindung betrifft einen manuell betätigbaren Drehschalter mit Tastfunktion für die Elektrotechnik/Elektronik.

### Stand der Technik

Auf dem Gebiet der Elektrotechnik/Elektronik sind die vielfältigsten Ausführungen von Drehschaltern bekannt. Zur Realisierung der Schalterstellungen werden mechanische Drehrastgesperre verwendet, wie sie beispielsweise in "Bauelemente der Feinwerktechnik" von O. Richter und R.v. Voss, 8. Auflage, Verlag Technik Berlin, 1959, S. 300 - 310 beschrieben werden. Zur Rastung der Schalterwelle stehen bei den meisten Ausführungen unter Federwirkung stehende Rastelemente wie Scheiben, Kugeln, Stifte usw. oder spezielle Federausführungen mit Rasträdern oder ähnlichen Bauelementen in Wirkverbindung.

Weiterhin ist aus der DE Patentschrift 29 03 698 eine magnetische Rastung in verschiedenster Anordnung der Rastelemente wie Permanentmagnet mit Mehrfachpolung oder mit Rastnasen aus magnetisierbaren Formelementen als Rotor oder Stator in Wechselwirkung mit dem gegenüberliegenden feststehenden Rastelement bekannt. Die Stellung und Teilung "T" der Rastaufnahme ist der Stellung und Teilung "T" der Signalerzeugungseinheit zugeordnet, woduch Signale Raststellungen nach einem festgelegten Muster entsprechen. Das entspricht der Erzeugung von definierten Signalen zu bestimmten Raststellungen.

Ebenfalls sind manuell bedienbare Tastenschalter verschiedener Ausführungen bekannt. Sie dienen dazu, durch axiale Tastung ein entsprechendes Signal zu erzeugen. Dabei werden auf verschiedenste Weise die dazu notwendigen Bewegungsabläufe unterstützt. Zum einen dienen mechanische Federelemente z.B. Zylinderfedern, Flachformfedern usw. dazu, als energiespeicherndes Umkehrelement meist im Zusammenhang mit Kontaktelementen oder selbst als energiespeicherndes Element zur Erzeugung des Taktimpulses meist in Verbindung mit verschiedenen Sensoren (Halleffekt, optoelektronisch usw.) als signalerzeugende Elemente zu fungieren. (DE Offenlegungsschrift 31 19 227) Weiterhin ist beispielsweise aus der DE Offenlegungsschrift 33 06 507 ein Tastenschalter bekannt, in dessen Gehäuse ein von einer magnetisch gerasteten Taste axial bewegbarer Permanentmagnet in den Wirkungsbereich von Schaltelementen zur Erzeugung elektrischer bzw. elektronischer Signale beispielsweise eines Schutzrohrkontaktes bewegt wird.

Gleichfalls ist aus der DE Offenlegungsschrift 23 13 750 ein Schalter oder Druckkontakt mit Energiespeicher und Sprungstelle bekannt, dessen axial bewegliches Schaltglied unter der Wirkung einer Zylinderfeder oder eines Ringes aus elastischem Werkstoff steht. Zur Unterstützung der Federwirkung ist ein Permanentmagnet am Schaltglied befestigt, der in Wirkverbindung mit einer ferromagnetischen Platte des Gerätegehäuses einen definierten Schaltpunkt eines elektrischen Kontaktes gewährleistet.

Weiterhin ist im DE Gebrauchsmuster 89 10 606.7 eine Drehknopf-Vorrichtung zum Auswählen bestimmter Funktionsarten eines Gerätes, insbesondere eines elektronischen Phoropters bekannt, bei der eine auf einer axial verschiebbaren Welle aus ferromagnetischem Material befestigte mit einer optoelektronischen Vorrichtung mit digitaler Weiterverarbeitung der Signale in Wirkverbindung stehende Polscheibe von einem im Gehäuse angeordneten Permanentmagneten verdrehgerastet wird. Bei axialer Verschiebung der Drehknopfachse kann ein weiterer Schaltvorgang realisiert werden.

Diese Schaltvorrichtungen sind Spezialbauelemente und dienen der Lösung spezieller Aufgaben.

Auch sind Drehschalter mit zusätzlich integrierter Möglichkeit der Erzeugung eines Signals durch axiale Bewegung der Schalterwelle realisiert, wobei Schnapp- und Rückstellkräfte durch Zylinder- oder Flachformfedern realisiert werden.

Die bekannten Schalter bzw. Schaltvorrichtungen sind durch ihre Größe in den Anwendungsmöglichkeiten beschränkt, z.B. in der Elektronik und Mikroelektronik oft überhaupt nicht einsetzbar. Die hierfür erforderliche Standzeit, Zuverlässigkeit und Präzision bekannter Bauteile oder Baugruppen beispielsweise von Rastelementen und solchen zur Erzeugung eines exakten Schnappeffektes wird nicht erreicht.

### Darstellung der Erfindung

Der Erfindung liegt die Aufgabe zugrunde, die Nachteile des Standes der Technik zu beseitigen und einen weiteren Drehschalter zu schaffen, bei dem exakt gerastete Drehschalt- und zusätzliche Tastfunktionen unabhängig voneinander möglich sind, der eine gute taktile Rückmeldung realisiert und eine miniaturisierte Bauweise zuläßt.

Diese Aufgabe wird erfindungsgemäß durch die Merkmale der Ansprüche 1 bis 8 gelöst.

Mit der Erfindung werden bei gedrungener raumsparender Bauweise in einem Bauelement der Elektrotechnik/Elektronik exakt gerastete Drehschalter- und zusätzliche Tastfunktionen unabhängig voneinander, d.h. sowohl eigenständig als auch gleichzeitig ermöglicht. Die Tastfunktion ermöglicht eine gute taktile Rückmeldung. Die Anordnung der Bauelemente und Baugruppen des Schalters läßt kleine und kleinste Ausführungen zu. Seine Rastung arbeitet verschleißarm und zuverlässig.

### Kurze Beschreibung der Zeichnung

In der zugehörigen Zeichnung zeigen
Fig. 1: die Erfindung im Schnitt,
Fig. 2: eine weitere Ausführung der Erfindung im Schnitt.

### Bester Weg zur Ausführung der Erfindung

Die Erfindung besteht im Wesentlichen aus einem Ringmagneten 1, einem Stator 2, Rastelementen 3, einer Welle 5, Scheiben 6;7, einer Codierscheibe 8, einer Abtasteinheit 9 und einem Anschlag 10.

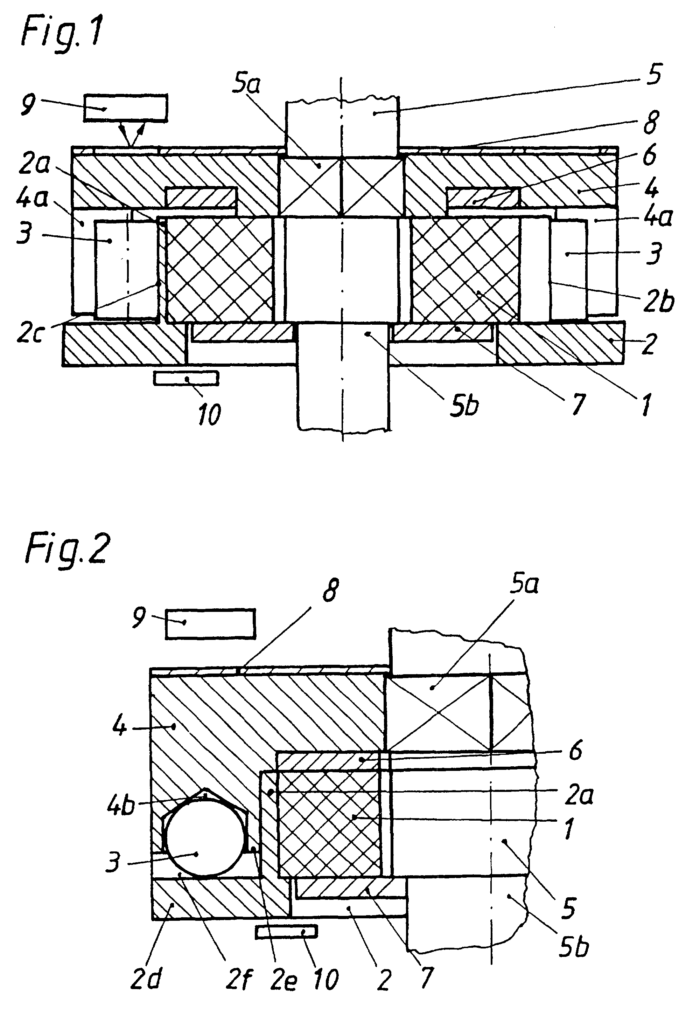

Wie aus Fig. 1 ersichtlich, ist im Zylinder 2a eines vorteilhaft aus nichtmagnetischem Material gefertigten Stators 2 des Drehschalters ein Ringmagnet 1 in bekannter Weise befestigt, beispielsweise leicht eingepreßt oder mit diesem verklebt.

Der Zylinder 2a ist als Rastkranz ausgebildet und mit Rasterhebungen 2b und Rastsenken 2c versehen, die walzen- oder kugelförmige Rastelemente 3 aufnehmen, welche durch die Kraftwirkung des Ringmagneten 1 definiert gehalten werden. Der Rastkranz hat übliche Formen bekannter Rastgesperre mit beliebiger Teilung, vorteilhaft eine Spitzverzahnung. Die Rastsenke 2c entspricht mit ihrer Teilung und Lage der Anzahl der möglichen Rastungen. Sie ist so geformt, daß sie die Rastelemente 3 in einer definierten Lage gerastet festhält. Die Rasterhebungen 2b bestimmen durch ihre Form und Höhe zur Rastsenke 2c und im Zusammenhang mit der Kraftwirkung des Ringmagneten 1 das Rastmoment und die Kraftabläufe während der Schaltbewegung. Dabei ist jede Rastsenke 2c so gestaltet, daß ihre Wanddicke im Zylinder 2a so gering wie möglich ist, um die Kraftwirkung des Ringmagneten 1 ohne Verluste also optimal umzusetzen. Andererseits kann die Variation der Wanddicke zum Einstellen des Rastmomentes herangezogen werden. Es können selbstverständlich Ringmagnete 1 mit unterschiedlicher Kraftwirkung verwendet werden.

Im Zentrum des Drehschalters ist eine axial verschiebbare Welle 5 drehbar gelagert, die mit einem Vierkant 5a oder mit anderen technischen Maßnahmen zur Gewährleistung eines Formschlusses und einem Ansatz 5b versehen ist. Das Vierkant 5a nimmt das Innenvierkant eines Mitnehmers 4 auf, der auf der oberen Stirnfläche des Ringmagneten 1 aufliegt und in dem eine Scheibe 6 aus ferro- oder weichmagnetischem Material befestigt ist, so daß durch die Zugkraft des Ringmagneten 1 die sichere Auflage gewährleistet ist. Im Mitnehmer 4 sind Führungen 4a zur Aufnahme der kugel- oder walzenförmigen Rastelemente 3 vorgesehen, die deren radiales Ausweichen beim Schalten gewährleisten. Auf der oberen Fläche des Mitnehmers 4 ist eine vorteilhaft auswechselbare Codierscheibe 8 befestigt, die den Wirkungsbereich einer optischen Abtasteinheit 9 für die weitere elektrische bzw. elektronische Auswertung optischer Signale passiert. Die Abtasteinheit 9 kann auch eine elektronische oder andersartige sein. An der unteren Stirnfläche des Ringmagneten 1 wird eine Scheibe 7 aus ferro- oder weichmagnetischem Material durch die Magnetkraft gehalten. Der Scheibe 7 ist ein Anschlag 10 zugeordnet. Beim Tasten also Drücken der Welle 5 erfolgt deren axiale Verschiebung, so daß die Haltekraft des Ringmagneten 1 überwunden wird und die Scheibe 7 schlagartig abreißt. Es entsteht eine starke positive Beschleunigung von Welle 5 und Scheibe 7 in axialer Richtung bis zum Anschlag 10. Beim Wegfall der Druckkraft auf die Welle 5 erfolgt infolge der Kraftwirkung des Ringmagneten 1 die Bewegung von Welle 5 und Scheibe 7 mit umgekehrter Beschleunigung in ihre Ausgangsstellung, was als Schnappeffekt, als taktile Rückmeldung fühlbar ist. Schalt- und Tastbewegung der Welle 5 sind gleichzeitig und unabhängig voneinander möglich. Bei einer Anordnung, bei der die Scheibe 7 gehäusefest und der Ringmagnet 1 drehbar auf der Welle 5 gelagert ist, reißt dieser bei Tastung von der Scheibe 7 ab, wodurch der gleich Schnappeffekt entsteht. Durch Variieren von Dicke und Durchmesser der Scheibe 7 lassen sich Beschleunigung von Welle 5 und Scheibe 7 und somit die Stärke des zu spürenden Schnappeffektes mit taktiler Rückmeldung in gewissen Grenzen beeinflussen.

Fig. 2 zeigt eine weitere Ausbildung des erfindungsgemäßen Schalters. Hierbei ist der Rastkranz mit den Rasterhebungen 2e und den Rastsenken 2f auf der Innenfläche des Ansatzes 2d angeordnet. Der Mitnehmer 4 ist mit vorteilhaft als Bohrungen ausgebildeten Führungen 4b versehen, die Rastelemente 3, vorteilhaft Kugeln, aufnehmen. Die Scheibe 6 wird mit dem Mitnehmer 4 durch die Kraftwirkung des Ringmagneten 1 an den Stator 2 gezogen. Beim Schalten vollführt der Mitnehmer 4 durch die Hubbewegung der Rastelemente 3 auf der Welle 5 eine axiale Verschiebung und wird um eine Teilung weiter geschaltet.

Magnetkraft, Größe und Dicke der Scheibe 6 und die Form des Rastkranzes sind maßgebend für die Güte der Rastung. Die erfindungsgemäßen Schalterausführungen sind von einem nicht dargestelltem Gehäuse umgeben.

### Gewerbliche Anwendbarkeit

Die Erfindung wird in manuell betätigbaren Drehschaltern mit Tastfunktion in Geräten der Elektrotechnik/Elektronik gewerblich genutzt.

## Patentansprüche

1. Drehschalter mit Tastfunktion, bestehend aus einem Grundkörper mit einer Rastung für eine drehbare Schalterwelle und elektrischen bzw. elektronischen Schaltelementen, **dadurch gekennzeichnet, daß** ein Stator (2) mit einem einen Ringmagneten (1) fassenden Zylinder (2a) versehen ist, daß der oberen Stirnseite des Ringmagneten (1) ein Mitnehmer (4) mit eingebetteter oberer Scheibe (6) aus ferromagnetischem oder weichmagnetischem Material, Führungen (4a; 4b) für Rastelemente (3), die ein Ausweichem beim Schalten gewährleisten, eine abtastbare Codierscheibe (8) und der unteren Stirnseite eine untere Scheibe (7) aus ferromagnetischem oder weichmagnetischem Material zugeordnet sind und daß im Zentrum eine dreh- und axial verschiebbare Welle (5) gelagert ist, die zum Mitnehmer (4) drehfest, aber axial verschiebbar ist und daß die untere Scheibe (7) durch eine axiale Bewegung der Welle (5) vom Ringmagneten (1) schnappartig wegbewegt wird.

2. Drehschalter mit Tastfunktion nach Anspruch 1, **dadurch gekennzeichnet, daß** die Welle (5) mit einem Vierkant (5a) und einem Ansatz (5b) versehen ist.

3. Drehschalter mit Tastfunktion nach Anspruch 1 bis 2, **dadurch gekennzeichnet, daß** der Codierscheibe (8) eine Abtasteinheit (9) zugeordnet ist.

4. Drehschalter mit Tastfunktion nach Anspruch 1 bis 3, **dadurch gekennzeichnet, daß** der Scheibe (7) ein Anschlag (10) zugeordnet ist.

5. Drehschalter mit Tastfunktion nach Anspruch 1 bis 4, **dadurch gekennzeichnet, daß** der Zylinder (2a) als Rastkranz mit Rasterhebungen (2b) und Rastelemente (3) aufnehmenden Rastsenken (2c) ausgebildet ist.

6. Drehschalter mit Tastfunktion nach Anspruch 1 bis 5, **dadurch gekennzeichnet, daß** die Rastelemente (3) in radial verlaufenden Führungen (4a) aufgenommen sind.

7. Drehschalter mit Tastfunktion nach Anspruch 1 bis 5, **dadurch gekennzeichnet, daß** der Stator (2) an der Innenfläche des Ansatzes (2d) mit einem Rastkranz mit Rasterhebungen (2e) und Rastsenken (2f) versehen ist.

8. Drehschalter mit Tastfunktion nach Anspruch 1 bis 5 und 7, **dadurch gekennzeichnet, daß** die kugelförmigen Rastelemente (3) in axial verlaufenden Führungen (4b) des Mitnehmers (4) angeordnet sind.

## Claims

1. Rotary switch with keying function comprising a base body with a latching arrangement for a rotatable switch shaft and electrical or electronic switching elements, **characterized in that** a stator (2) is provided with a cylinder (2a) containing a ring magnet (1); **in that** a driver (4) with an embedded upper disk (6) of ferromagnetic or soft magnetic material, guides (4a; 4b) for latch elements (3) which permit a deviation during switching and a code disc (8) are associated with the upper end face of the ring magnet (1), and a lower disc (7) of ferromagnetic or soft magnetic material is associated with the lower end face; and **in that** a rotationally and axially displaceable shaft (5) is rotationally and axially journalled in the centre and **in that** the lower disc (7) is moved with a snap action away from the ring magnet (1) by an axial movement of the shaft (5).

2. Rotary switch with keying function in accordance with claim 1, **characterized in that** the shaft (5) is provided with a square section (5a) and a projection (5b).

3. Rotary switch with keying function in accordance with claim 1 to 2, **characterized in that** a sensing unit (9) is associated with the code disc (8).

4. Rotary switch with keying function in accordance with claim 1 to 3, **characterized in that** an abutment (10) is associated with the disc (7).

5. Rotary switch with keying function in accordance with claim 1 to 4, **characterized in that** the cylinder (2a) is formed as a latching ring with raised latch portions (2b) and latch recesses (2c) receiving latch elements (3).

6. Rotary switch with keying function in accordance with claim 1 to 5, **characterized in that** the latch elements (3) are received in radially extending guides (4a).

7. Rotary switch with keying function in accordance with claim 1 to 5, **characterized in that** the stator (2) is provided at the inner surface of the projection (2d) with a latching ring with latch projections (2e) and latch recesses (2f).

8. Rotary switch with keying function in accordance with claim 1 to 5 and 7, **characterized in that** the ball-like latch elements (3) are arranged in axially extending guides (4b) of the driver (4).

## Revendications

1. Commutateur tournant à fonction de touche, constitué d'un corps de base avec des crans d'arrêt pour un arbre de sélecteur tournant et des éléments de commutation électriques et électroniques, **caractérisé en ce qu'**un stator (2) est pourvu d'un cylindre (2a) renfermant un aimant annulaire (1), **en ce que** sont associés au côté frontal supérieur de l'aimant annulaire (1) un entraîneur (4) à disque supérieur noyé (6) en un matériau ferromagnétique ou magnétique doux, des guidages (4a ; 4b) pour des éléments d'enclenchement (3) qui assurent un évitement lors de la commutation, un disque de codage (8) apte à être balayé et au côté frontal inférieur un disque inférieur (7) en matériau ferromagnétique ou magnétique doux, et qu'il est logé au centre un arbre (5) pouvant être entraîné en rotation et déplacé axialement, qui est fixe relativement à l'entraîneur (4), mais déplaçable axialement, et **en ce que** le disque inférieur (7). est déplacé à enclenchement par un mouvement axial de l'arbre (5) par l'aimant annulaire (1).

2. Commutateur tournant à fonction de touche selon la revendication 1, **caractérisé en ce que** l'arbre (5) est pourvu d'un quatre-pans (5a) et d'un bout rapporté (5b).

3. Commutateur tournant à fonction de touche selon la revendication 1 à 2, **caractérisé en ce qu'**une unité de balayage (9) est associée au disque de codage (8).

4. Commutateur tournant à fonction de touche selon la revendication 1 à 3, **caractérisé en ce qu'**une butée (10) est associée au disque (7).

5. Commutateur tournant à fonction de touche selon la revendication 1 à 4, **caractérisé en ce que** le cylindre (2) est réalisé sous forme de couronne à crans avec des surélévations formant cran (2b) et des creux formant cran (2c) recevant des élément d'enclenchement (3).

6. Commutateur tournant à fonction de touche selon la revendication 1 à 5, **caractérisé en ce que** les éléments d'enclenchement (3) sont reçus dans des guidages (4a) s'étendant radialement.

7. Commutateur tournant à fonction de touche selon la revendication 1 à 5, **caractérisé en ce que** le stator (2) est pourvu à la face intérieure du bout rapporté (2d) d'une couronne à crans avec des surélévations formant cran (2e) et des creux formant cran (2f).

8. Commutateur tournant à fonction de touche selon la revendication 1 à 5 et 7, **caractérisé en ce que** les éléments d'enclenchement sphériques (3) sont disposés dans des guidages (4b) s'étendant axialement de l'entraîneur (4).
